# EUROPÄISCHE PATENTSCHRIFT

(11) **EP 2 517 270 B1**
(45) Veröffentlichungstag und Bekanntmachung des Hinweises auf die Patenterteilung: **12.09.2018**
(21) Anmeldenummer: 10788084.1
(22) Anmeldetag: 13.12.2010
(51) Int. Cl.: H01L 33/58, H01L 33/50

(54) **STRAHLUNGSEMITTIERENDES HALBLEITERBAUELEMENT**
RADIATION-EMITTING SEMICONDUCTOR COMPONENT
COMPOSANT SEMI-CONDUCTEUR ÉMETTANT UN RAYONNEMENT

(30) Priorität: 20.01.2010 DE 102010005169; 21.12.2009 DE 102009059878
(43) Veröffentlichungstag der Anmeldung: 31.10.2012
(73) Patentinhaber: OSRAM Opto Semiconductors GmbH, 93055 Regensburg (DE)
(72) Erfinder: BERGENEK, Krister, 93059 Regensburg (DE); AHLSTEDT, Mikael, 80686 München (DE); LIEPOLD, Ute, 80939 München (DE)
(74) Vertreter: Epping - Hermann - Fischer
(86) Internationale Anmeldenummer: PCT/EP2010/069509
(87) Internationale Veröffentlichungsnummer: WO 2011/085889

(56) Entgegenhaltungen:
- EP-A2- 1 906 462
- DE-A1-102004 052 456
- DE-A1-102006 061 175
- DE-A1-102008 021 621
- US-A1- 2004 188 689
- US-A1- 2005 285 132
- US-A1- 2009 278 147
- BERGENEK K ET AL: "Strong High Order Diffraction of Guided Modes in Micro-Cavity Light-Emitting Diodes With Hexagonal Photonic Crystals", IEEE JOURNAL OF QUANTUM ELECTRONICS, IEEE SERVICE CENTER, PISCATAWAY, NJ, USA, Bd. 45, Nr. 12, 1. Dezember 2009 (2009-12-01), Seiten 1517-1523, XP011284619, ISSN: 0018-9197, DOI: DOI:10.1109/JQE.2009.2021958

## Beschreibung

Die Erfindung betrifft ein strahlungsemittierendes Halbleiterbauelement, insbesondere eine LED mit einer Lumineszenzkonversionsschicht.

Auf dem Prinzip der Lumineszenzkonversion basierende LEDs können dadurch hergestellt werden, dass eine Lumineszenzkonversionsschicht auf einen strahlungsemittierenden Halbleiterchip aufgebracht wird, die einen Teil der von dem Halbleiterchip emittierten Strahlung einer ersten Wellenlänge in Strahlung einer zweiten Wellenlänge konvertiert, die größer ist als die erste Wellenlänge. Die Lumineszenzkonversionsschicht kann beispielsweise einen Lumineszenzkonversionsstoff enthalten, der von einem Halbleiterchip emittiertes ultraviolettes oder blaues Licht zumindest teilweise in gelbes Licht umwandelt, so dass sich durch Überlagerung der emittierten ultravioletten oder blauen Strahlung und der konvertierten gelben Strahlung weißes Mischlicht ergibt.

Eine auf dem Prinzip der Lumineszenzkonversion basierende LED sowie geeignete Lumineszenzkonversionsstoffe sind beispielsweise aus der Druckschrift WO 97/50132 bekannt. In DE 10 2004 052456 wird ein Bauelement beschrieben, das geeignet ist, elektromagenetische Strahlung zu emittieren, und folgende Elemente umfasst:
- mindestens eine primäre Strahlungsquelle, die geeignet ist, elektromagnetische Primärstrahlung eines ersten Wellenlängenbereiches zu emittieren,
- mindestens ein Lumineszenzkonversionselement, das zumindest einen Teil der von der primären Strahlungsquelle stammenden Strahlung in Strahlung eines zweiten Wellenlängenbereiches konvertiert, der zumindest teilweise vom ersten Wellenlängenbereich verschieden ist, und
- ein dem Lumineszenzkonversionselement aus Sicht der primären Strahlungsquelle nachgeordnetes Filterelement mit einem dreidimensionalen photonischen Kristall, der derart ausgelegt ist, dass er für die Emission unerwünschte Strahlung des ersten Wellenlängenbereiches weitestgehend undurchlässig ist und diese reflektiert, und gleichzeitig für Strahlung des zweiten Wellenlängenbereiches weitestgehend durchlässig ist.

EP 1 906 462 offenbart ein optoelektronisches Bauelement mit einer aktiven Schicht, die beim Betrieb des Bauelements elektromagnetische Strahlung emittiert, und einer der aktiven Schicht in einer Abstrahlrichtung der elektromagnetischen

Strahlung nachfolgenden Lumineszenzkonversionsschicht in der Abstrahlrichtung eine lichtstreuende transluzente Schicht nachfolgt. Die Lumineszenzkonversionssicht erscheint aufgrund der ihr nachfolgenden lichtstreuenden transluzenten Schicht vorzugsweise weiß.

DE 10 2006 061175 offenbart ein strahlungsemittierendes Halbleiterbauelement mit einem Halbleiterchip, einem Lumineszenzkonversionselement und einem Diffusorelement. Das Diffusorelement ist plättchenförmig ausgebildet und ist so an dem Lumineszenzkonversionselement angeordnet, dass es streuend wirkt bezüglich der von dem Halbleiterchip emittierten und der von dem mindestens einen Leuchtstoff mit veränderter Wellenlänge wieder emittierten elektromagnetischen Strahlung, die auf das Diffusorelement trifft.

Der Lumineszenzkonversionsstoff ist typischerweise in ein organisches Material wie beispielsweise ein Epoxidharz oder Silikon eingebunden, wobei die Lumineszenzkonversionsschicht als Vergussmasse auf den Halbleiterchip aufgebracht wird.

Bei LEDs, die auf dem Prinzip der Lumineszenzkonversion beruhen, kann eine unerwünschte Winkelabhängigkeit des Farborts auftreten. Dies beruht darauf, dass unter großen Ausfallswinkeln emittierte Strahlung einen längeren Weg durch die Lumineszenzkonversionsschicht zurücklegt und somit ein größerer Anteil der emittierten ultravioletten oder blauen Strahlung in gelbes Licht konvertiert wird.

Ein für bestimmte Anwendungen weiterer unerwünschter Effekt ist, dass die Lumineszenzkonversionsschicht im ausgeschalteten Zustand der LED einen unerwünschten gelben Farbeindruck bietet.

Der Erfindung liegt die Aufgabe zugrunde, ein strahlungsemittierendes Halbleiterbauelement mit einer Lumineszenzkonversionsschicht anzugeben, das sich durch eine verbesserte Strahlungsauskopplung, eine verbesserte Farbmischung und/oder Direktionalität der emittierten Strahlung auszeichnet.

Diese Aufgabe wird durch ein strahlungsemittierendes Halbleiterbauelement mit den Merkmalen des Anspruchs 1 gelöst. Vorteilhafte Ausgestaltungen und Weiterbildungen der Erfindung sind Gegenstand der abhängigen Ansprüche. Beispiele, die nicht unter die Begriffe der Definition von Anspruch 1 fallen, sind kein Bestandteil der vorliegenden Erfindung, obwohl sie zum Teil in der Beschreibung als "Ausführungsformen" bezeichnet sind. Sie sind lediglich Beispiele, die für das Verständnis der vorliegenden Erfindung hilfreich sind. Gemäß zumindest einer Ausführungsform weist ein strahlungsemittierendes Halbleiterbauelement einen Halbleiterkörper auf, der eine aktive Schicht enthält, die im Betrieb elektromagnetische Strahlung einer ersten Wellenlänge λ₁ in eine Hauptstrahlrichtung emittiert. Das strahlungsemittierende Halbleiterbauelement kann insbesondere eine LED sein. Die aktive Schicht kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung die Quantentopfstruktur keine Angabe über die Dimensionalität der Quantisierung. Sie umfasst somit unter anderem Quantentröge, Quantendrähte und Quantenpunkte und jede Kombination dieser Strukturen.

Der Halbleiterkörper kann insbesondere auf einem Nitridverbindungshalbleiter basieren. "Auf einem Nitridverbindungshalbleiter basierend" bedeutet im vorliegenden Zusammenhang, dass die Halbleiterschichtenfolge oder zumindest eine Schicht davon ein III-Nitrid-Verbindungshalbleitermaterial, vorzugsweise InₓAl_{y}Ga_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des InₓAl_{y}Ga_{1-x-y}N-Materials im Wesentlichen nicht ändern. Der Einfachheit halber beinhaltet obige Formel jedoch nur die wesentlichen Bestandteile des Kristallgitters (In, Al, Ga, N), auch wenn diese teilweise durch geringe Mengen weiterer Stoffe ersetzt sein können.

Die aktive Schicht des Halbleiterkörpers emittiert im Betrieb des Halbleiterbauelements vorzugsweise ultraviolette oder blaue Strahlung.

Weiterhin enthält das strahlungsemittierende Halbleiterbauelement eine Lumineszenzkonversionsschicht, die zumindest einen Teil der emittierten Strahlung der ersten Wellenlänge λ₁ in Strahlung einer zweiten Wellenlänge λ₂ konvertiert, die größer ist als die erste Wellenlänge λ₁. Die Lumineszenzkonversionsschicht kann insbesondere einen Lumineszenzkonversionsstoff aufweisen, der geeignet ist, blaues oder ultraviolettes Licht zumindest teilweise in gelbes Licht umzuwandeln. Geeignete Lumineszenzkonversionsstoffe sind beispielsweise aus der in der Einleitung genannten Druckschrift WO 97/50132 bekannt, deren Inhalt diesbezüglich hiermit durch Rückbezug aufgenommen wird. Die Lumineszenzkonversionsschicht kann mindestens einen weiteren Lumineszenzkonversionsstoff aufweisen, der die Strahlung der von der aktiven Schicht emittierte Strahlung in Strahlung mindestens einer weiteren Wellenlänge konvertiert. Mehrere Konversionsstoffe können insbesondere dazu eingesetzt werden, den Farbort der Mischstrahlung gezielt einzustellen, zum Beispiel zur Erzeugung von Warmweiß-Licht.

Weiterhin enthält das strahlungsemittierende Halbleiterbauelement eine Funktionsschicht zur Verbesserung der Strahlungsauskopplung, Farbmischung und/oder Winkelabhängigkeit der emittierten Strahlung. Die Funktionsschicht folgt der aktiven Schicht in der Hauptstrahlungsrichtung nach und enthält vorzugsweise ein Glas, eine Keramik, eine Glaskeramik oder Saphir. Die Funktionsschicht aus einem dieser Materialien kann insbesondere eine selbsttragende Schicht sein, die vorteilhaft als mechanisch stabiler Träger für weitere Schichten dienen kann. Vorzugsweise ist die Funktionsschicht eine formstabile Schicht, die vorteilhaft unabhängig von dem Halbleiterkörper hergestellt und strukturiert werden kann, um sie nachträglich mit dem Halbleiterkörper und/oder der Lumineszenzkonversionsschicht zu verbinden.

Die Funktionsschicht folgt der Lumineszenzkonversionsschicht in der Hauptstrahlungsrichtung nach. Insbesondere kann die Funktionsschicht unmittelbar an die Lumineszenzkonversionsschicht angrenzen. Die Funktionsschicht weist vorzugsweise die Strahlungsauskoppelfläche des strahlungsemittierenden Halbleiterbauelements auf, das heißt sie ist vorteilhaft die in der Hauptstrahlungsrichtung gesehen äußerste Schicht des strahlungsemittierenden Halbleiterbauelements.

Gemäß einer bevorzugten Ausführungsform weist die Lumineszenzkonversionsschicht einen Brechungsindex n₁ und die Funktionsschicht einen Brechungsindex n₂ auf, wobei n₂ ≤ n₁ gilt.

Bei einer Ausgestaltung ist der Brechungsindex n₂ der Funktionsschicht an den Brechungsindex n₁ der Lumineszenzkonversionsschicht angepasst. In diesem Fall sind die Brechungsindizes n₁ und n₂ sind gleich oder unterscheiden sich nur geringfügig voneinander, vorteilhaft um Δn = |n₂ -n₁| ≤ 0,3 und bevorzugt um Δn ≤ 0,1. Besonders bevorzugt ist n2 = n1 - Δn mit 0 ≤ Δn ≤ 0,1, d.h. n₂ ist gleich oder geringfügig kleiner als n₁.

Auf diese Weise werden vorteilhaft Reflexionsverluste beim Übergang der emittierten Strahlung von der Lumineszenzkonversionsschicht in die nachfolgende Funktionsschicht vermieden. Dies ist insbesondere dann vorteilhaft, wenn die Funktionsschicht an einer von der Lumineszenzkonversionsschicht abgewandten Oberfläche eine Oberflächenstruktur zur Verbesserung der Strahlungsauskopplung aufweist. In diesem Fall werden durch die Anpassung des Brechungsindex der Funktionsschicht an den Brechungsindex der Lumineszenzkonversionsschicht Reflexionsverluste an der Grenzfläche zwischen der Lumineszenzkonversionsschicht und der Funktionsschicht minimiert, während Reflexionsverluste an der Grenzfläche zwischen der Funktionsschicht und dem Umgebungsmedium durch die Oberflächenstrukturierung der Funktionsschicht verringert werden.

Bei einer alternativen Ausgestaltung ist der Brechungsindex n₂ der Funktionsschicht kleiner als der Brechungsindex n₁ der Lumineszenzkonversionsschicht. In diesem Fall sind Reflexionsverluste an der Grenzfläche zwischen der Funktionsschicht und dem Umgebungsmedium vorteilhaft geringer, als wenn ein direkter Übergang von dem Brechungsindex der Lumineszenzkonversionsschicht zum Brechungsindex des Umgebungsmediums wie insbesondere Luft erfolgen würde.

Es ist auch möglich, dass die Funktionsschicht zwei oder mehr Teilschichten aufweist, wobei die Brechungsindizes der Teilschichten in der Hauptstrahlungsrichtung von Teilschicht zu Teilschicht abnehmen. Weiterhin ist es auch denkbar, dass die Funktionsschicht eine in der Hauptstrahlungsrichtung kontinuierlich variierende Materialzusammensetzung aufweist, so dass die Funktionsschicht einen Brechzahlgradienten aufweist, bei dem der Brechungsindex in der Hauptstrahlungsrichtung kontinuierlich abnimmt. Bei diesen Ausgestaltungen werden Reflexionsverluste durch sprunghafte Änderungen des Brechungsindex verringert und somit die Auskoppeleffizienz des strahlungsemittierenden Halbleiterbauelements verbessert.

Bei einer bevorzugten Ausführungsform weist die Lumineszenzkonversionsschicht eine Keramik auf. Bei der Keramik kann es sich insbesondere um YAG:Ce oder LuAG:Ce handeln. Weiterhin sind auch Eu-dotierte Nitride oder Oxinitride geeignet. Alternativ kann die Lumineszenzkonversionsschicht auch ein Glas oder eine Glaskeramik aufweisen, in die der Lumineszenzkonversionsstoff eingebunden ist.

Geeignete Keramiken für die Funktionsschicht sind insbesondere Aluminiumoxid (n₂ = 1,76 - 1,77), Aluminiumoxinitrid (n₂ = 1,77 - 1,80), Magnesium-Aluminium-Spinell (n₂ = 1,73), Siliziumdioxid (n₂= 1,46) oder Siliziumoxinitrid (n₂ = 1,47). Geeignete Gläser für die Funktionsschicht sind insbesondere Quarzglas (n₂ = 1,46), amorphes Germaniumoxid (GeO₂, n₂ = 1,61), Natron-Kalk-Glas (n₂ = 1,52), Silikatglas (n₂ = 1,50) oder Borosilikatglas (n₂ = 1,47). Die genannten Keramiken und Gläser weisen jeweils einen Brechungsindex auf, der annähernd gleich dem Brechungsindex der beispielsweise für die Lumineszenzkonversionsschicht geeigneten Keramik YAG:Ce (n₁ = 1,81) oder geringer ist. Bei dem Glas kann es sich auch um ein Spin-on-Glas handeln. Neben Keramiken und Gläsern sind auch Glaskeramiken für die Funktionsschicht geeignet.

Die Lumineszenzkonversionsschicht und die Funktionsschicht können insbesondere durch Sintern und/oder Schmelzen miteinander verbunden werden. In diesem Fall erfolgt die Verbindung vorteilhaft haftvermittlerfrei, das heißt zwischen der Funktionsschicht und der Lumineszenzkonversionsschicht ist vorteilhaft keine Verbindungsschicht wie beispielsweise eine Klebstoffschicht angeordnet. Strahlungsverluste durch Reflexion oder Streuung, die im Fall einer zwischen der Lumineszenzkonversionsschicht und der Funktionsschicht angeordneten Klebstoffsschicht auftreten könnten, werden auf diese Weise verhindert.
Die Lumineszenzkonversionsschicht und die Funktionsschicht können alternativ aber auch durch eine chemische Verbindung, insbesondere mit einer Verbindungsschicht aus einem transparenten Material wie beispielsweise Silikon oder einem anderen transparenten Gießharz miteinander verbunden werden. Auf diese Weise kann zum Beispiel auch die Lumineszenzkonversionsschicht mit dem Halbleiterkörper verbunden werden.

Gemäß der Erfindung weist die Funktionsschicht eine Oberflächenstrukturierung auf. Die Oberflächenstrukturierung ist vorteilhaft an der von der Lumineszenzkonversionsschicht abgewandten Oberfläche der Funktionsschicht ausgebildet, die insbesondere die Strahlungsaustrittsfläche des strahlungsemittierenden Halbleiterbauelements darstellt. Durch die Oberflächenstrukturierung können insbesondere Reflexionsverluste an der Grenzfläche zwischen der Funktionsschicht und dem Umgebungsmedium vermindert werden, wodurch sich die Strahlungsauskopplung und somit die Effizienz des strahlungsemittierenden Halbleiterbauelements verbessert.

Die Oberflächenstrukturierung weist vorzugsweise eine Tiefe zwischen 100 nm und 10 µm auf. Beispielsweise können an der Oberfläche der Funktionsschicht Ausnehmungen ausgebildet sein, die sich vorzugsweise zwischen 100 nm und 10 µm weit bis in die Funktionsschicht hinein erstrecken.

Gemäß der Erfindung weist die Oberflächenstrukturierung eine periodische Struktur auf. Die periodische Struktur kann eine ein- oder zweidimensionale Periodizität aufweisen, wobei aber auch dreidimensionale Strukturen möglich sind. Insbesondere kann die periodische Struktur eine Periode d aufweisen, die in der Größenordnung der Wellenlänge der emittierten Strahlung liegt. Die periodische Struktur bildet in diesem Fall einen so genannten photonischen Kristall aus.

Erfindungsgemäß weist die periodische Struktur eine Periode d und die Funktionsschicht einen Brechungsindex n₂ auf wobei gilt: π/λ₂ < G < n₂ 2π/λ₂. Dabei ist λ₂ die Wellenlänge der konvertierten Strahlung und G = 2π/d im Fall einer eindimensionalen Gitterstruktur und G = 4π/√3d im Fall einer zweidimensionalen, insbesondere hexagonalen, Gitterstruktur.
Es hat sich herausgestellt, dass sich bei einer derartigen Wahl der Periode d der periodischen Struktur eine gerichtete Abstrahlung in eine Hauptstrahlungsrichtung erzielen lässt, die senkrecht zur Oberfläche der Funktionsschicht ist.

Die Oberflächenstrukturierung kann in nicht erfindungsgemäßen Beispielen auch eine Aufrauung sein. In diesem Fall weist die Oberflächenstrukturierung also eine nicht-periodische Struktur auf. Die Oberflächenstrukturierung kann in diesem Fall insbesondere durch einen Ätzprozess erzeugt werden.
In einer weiteren bevorzugten Ausführungsform weist die Funktionsschicht Streupartikel oder Poren auf.
Durch Lichtstreuung an den Streupartikeln oder Poren in der Funktionsschicht wird die Farbmischung zwischen der von dem Halbleiterkörper und dem Konversionsstoff emittierten Strahlung verbessert und auf diese Weise insbesondere die Winkelabhängigkeit des Farborts verringert.
Die Lumineszenzkonversionsschicht selbst weist vorteilhaft keine Streupartikel auf. Im Fall einer erwünschten Lichtstreuung sind die Streupartikel und/oder eine lichtstreuende Struktur also vorzugsweise nur in der Funktionsschicht angeordnet bzw. ausgebildet. Dies hat den Vorteil, dass die Effizienz der Lumineszenzkonversion in der Lumineszenzkonversionsschicht nicht durch die Streupartikel beeinträchtigt wird.
Bei einer vorteilhaften Ausgestaltung weist die Funktionsschicht zwei oder mehr Teilschichten auf, wobei die Konzentration der Streupartikel oder Poren der Teilschichten in der Hauptstrahlungsrichtung von Teilschicht zu Teilschicht abnimmt. Weiterhin ist es auch denkbar, dass die Funktionsschicht eine in der Hauptstrahlungsrichtung kontinuierlich abnehmende Konzentration von Streupartikeln oder Poren aufweist.

Bei einer weiteren Ausführungsform ist die Funktionsschicht eine Teilschicht der Lumineszenzkonversionsschicht. In diesem Fall ist die Funktionsschicht vorzugsweise an einer von der aktiven Schicht abgewandten Oberfläche der Lumineszenzkonversionsschicht ausgebildet. Insbesondere kann die von der aktiven Schicht abgewandte Oberfläche der Lumineszenzkonversionsschicht mit der zuvor beschriebenen Oberflächenstrukturierung versehen sein. Im Gegensatz zu den zuvor beschriebenen Varianten, bei denen die Funktionsschicht eine von der Lumineszenzkonversionsschicht verschiedene separate Schicht ist, hat die Ausbildung der Funktionsschicht an der Oberfläche der Lumineszenzkonversionsschicht den Vorteil, dass keine zwei separaten Elemente miteinander verbunden werden müssen.

Eine von der Lumineszenzkonversionsschicht verschiedene Funktionsschicht hat dagegen den Vorteil, dass für die Funktionsschicht ein anderes Material als für die Lumineszenzkonversionsschicht ausgewählt werden kann, so dass Materialparameter wie insbesondere der Brechungsindex der Funktionsschicht gezielt ausgewählt werden können.

Die Erfindung wird im Folgenden anhand von Ausführungsbeispielen im Zusammenhang mit den Figuren 1 bis 13 näher erläutert.

Es zeigen:
Figur 1 eine schematische Darstellung eines Querschnitts durch ein strahlungsemittierendes Halbleiterbauelement gemäß einem ersten Ausführungsbeispiel,
Figur 2 eine schematische Darstellung eines Querschnitts durch die Funktionsschicht bei einem weiteren Ausführungsbeispiel,
Figur 3 eine schematische Darstellung eines Querschnitts durch die Funktionsschicht bei einem weiteren Ausführungsbeispiel, und
Figuren 4 bis 13 jeweils eine schematische Darstellung eines Querschnitts durch ein strahlungsemittierendes Halbleiterbauelement gemäß weiteren Ausführungsbeispielen.

Gleiche oder gleich wirkende Bestandteile sind in den Figuren mit den gleichen Bezugszeichen versehen. Die Größen der Bestandteile sowie die Größenverhältnisse der Bestandteile untereinander sind nicht als maßstabsgerecht anzusehen.

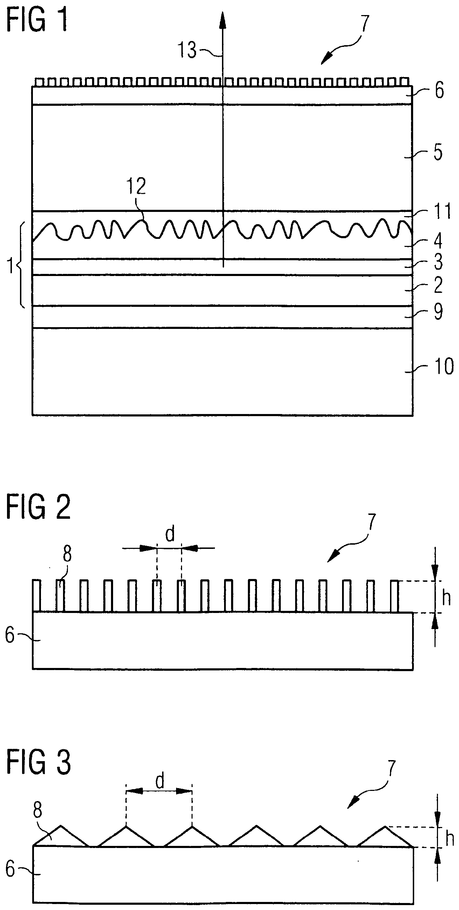

Das in Figur 1 dargestellte Ausführungsbeispiel eines strahlungsemittierenden Halbleiterbauelements weist einen Halbleiterkörper 1 auf, der eine strahlungsemittierende aktive Schicht 3 enthält. Bei der aktiven Schicht 3 kann es sich insbesondere um einen pn-Übergang, eine Einfach-Quantentopfstruktur oder eine Mehrfach-Quantentopfstruktur handeln. Die aktive Schicht kann insbesondere Strahlung im ultravioletten oder blauen Spektralbereich emittieren. Insbesondere kann die aktive Schicht aus einem Nitridverbindungshalbleitermaterial gebildet sein. Die aktive Schicht ist beispielsweise zwischen einem p-Typ-Halbleiterbereich 2 und einem n-Typ-Halbleiterbereich 4 angeordnet.

Bei dem Halbleiterkörper 1 handelt es sich um einen so genannten Dünnfilm-Halbleiterkörper, bei dem ein zum

Aufwachsen der Halbleiterschichten 2, 3, 4 verwendetes Aufwachssubstrat von dem Halbleiterkörper 1 abgelöst worden ist. An einer dem ursprünglichen Aufwachssubstrat gegenüberliegenden Seite ist der Halbleiterkörper 1 mit einem Trägerkörper 10 verbunden.

Zwischen dem Halbleiterkörper 1 und dem Trägerkörper 10 ist vorzugsweise eine Spiegelschicht 9 angeordnet, die gleichzeitig zur elektrischen Kontaktierung des Halbeleiterkörpers 1 dienen kann. Die Spiegelschicht 9 kann insbesondere Ag oder Al enthalten. Eine weitere elektrische Kontaktschicht (nicht dargestellt) kann beispielsweise auf einen Teilbereich der von dem Trägerkörper 10 abgewandten Oberfläche 12 des Halbleiterkörpers 1 aufgebracht sein. Zwischen dem Trägerkörper 10 und dem Halbleiterkörper 1 können noch weitere Schichten (nicht dargestellt) angeordnet sein, insbesondere eine Lotschicht zum Verbinden des Halbleiterkörpers 1 mit dem Trägerkörper 10.

Die von dem Trägerkörper 10 abgewandte Oberfläche 12 des Halbleiterkörpers 1 weist vorteilhaft eine Oberflächenstrukturierung zur Verbesserung der Strahlungsauskopplung aus dem Halbleiterkörper 1 auf.

Von der aktiven Schicht 3 des Halbleiterkörpers 1 wird elektromagnetische Strahlung, die ein Intensitätsmaximum bei einer Wellenlänge λ₁ aufweist, in eine Hauptstrahlungsrichtung 13 emittiert. Der aktiven Schicht ist in der Hauptstrahlungsrichtung 13 eine Lumineszenzkonversionsschicht 5 nachgeordnet, die zumindest einen Teil der emittierten Strahlung in Strahlung mit einem Intensitätsmaximum bei einer zweiten Wellenlänge λ₂ konvertiert, die größer als die erste Wellenlänge λ₁ ist. Insbesondere kann die Lumineszenzkonversionsschicht 5 von der aktiven Schicht 3 emittiertes blaues oder ultraviolettes Licht in gelbes Licht umwandeln, so dass die Überlagerung der Komplementärfarben Weißlicht ergibt.

Die Lumineszenzkonversionsschicht 5 ist vorzugsweise eine selbsttragende Schicht, die insbesondere aus einem anorganischen Material gebildet sein kann. Bevorzugt weist die Lumineszenzkonversionsschicht 5 ein Glas, eine Keramik oder eine Glaskeramik auf. Insbesondere kann die Lumineszenzkonversionsschicht 5 Ce-dotierte Granate wie beispielsweise YAG:Ce oder LuAG:Ce aufweisen. Weiterhin sind auch Eu-dotierte Nitride oder Oxinitride wie z.B. Sr₂Si₅N₈, Ba₂Si₅N₈, Ca₂Si₅N₈, Sr-SiON, Ba-SiON oder Ca-α-SiAlON geeignet.

Die Lumineszenzkonversionsschicht 5 ist beispielsweise durch eine Verbindungsschicht 11 mit dem Halbleiterkörper 1 verbunden. Bei der Verbindungsschicht 11 kann es sich insbesondere um eine transparente Schicht aus Silikon oder einem anderen Gießharz wie beispielsweise Epoxidharz handeln.

Dadurch, dass die Lumineszenzkonversionsschicht 5 eine selbsttragende Schicht aus einem vorzugsweise anorganischen Material ist, kann sie vorteilhaft als Träger für eine weitere Schicht dienen. Der Lumineszenzkonversionsschicht 5 ist in der Hauptstrahlungsrichtung 13 eine Funktionsschicht 6 nachgeordnet. Die Funktionsschicht 6 dient insbesondere zur Verbesserung der Strahlungsauskopplung aus der Lumineszenzkonversionsschicht 5. Die Funktionsschicht 6 ist wie die Lumineszenzkonversionsschicht 5 vorteilhaft aus einem anorganischen Material, insbesondere aus einer Keramik, einem Glas oder einer Glaskeramik gebildet. Geeignete Keramiken für die Funktionsschicht 6 sind beispielsweise Aluminiumoxid, (Al₂O₃), Aluminiumoxinitrid (AlON), Magnesium-Aluminium-Spinel (MgAl₂O₃), Siliziumdioxid (SiO₂) oder Siliziumoxinitrid (SiON). Geeignete Gläser für die Funktionsschicht 6 sind insbesondere Quarzglas, amorphes Germaniumoxid (Fused Germania), Natron-Kalk-Glas, Silikatglas oder Borosilikatglas. Diese Keramiken und Gläser zeichnen sich insbesondere dadurch aus, dass der Brechungsindex geringer ist als der Brechungsindex von YAG:Ce, das als Material für die Lumineszenzkonversionsschicht besonders geeignet ist.

Die auf die Lumineszenzkonversionsschicht 5 aufgebrachte Funktionsschicht 6 ist vorteilhaft weniger als 100 µm dick, beispielsweise zwischen 10 µm und 100 µm. Vorzugsweise grenzen die Lumineszenzkonversionsschicht 5 und die Funktionsschicht 6 direkt aneinander an und sind haftvermittlerfrei miteinander verbunden, das heißt zwischen der Lumineszenzkonversionsschicht 5 und der Funktionsschicht 6 ist vorteilhaft keine Verbindungsschicht enthalten. In diesem Fall können die Funktionsschicht 6 und die Lumineszenzkonversionsschicht 5 beispielsweise durch Sintern oder Schmelzen miteinander verbunden sein.

Es ist vorteilhaft, wenn der Brechungsindex n₂ der Funktionsschicht 6 an den Brechungsindex n₁ der Lumineszenzkonversionsschicht 5 angepasst ist, wobei vorzugsweise Δn = |n₂ - n₁| ≤ 0,3 gilt. Besonders bevorzugt gilt Δn ≤ 0,1. Wenn die Brechungsindizes der Lumineszenzkonversionsschicht 5 und der Funktionsschicht 6 zumindest annähernd gleich sind, treten an der Grenzfläche zwischen der Lumineszenzkonversionsschicht 5 und der Funktionsschicht 6 keine oder nur geringfügige Reflexionsverluste auf. Ein Brechungsindexsprung zum Umgebungsmedium findet in diesem Fall im Wesentlichen an der Grenzfläche zwischen der Funktionsschicht 6 und dem Umgebungsmedium, insbesondere Luft, statt. Zur Verminderung von Reflexionsverlusten und somit zur Verbesserung der Strahlungsauskopplung aus der Funktionsschicht 6 weist die Funktionsschicht 6 eine Oberflächenstrukturierung 7 auf. Die Oberflächenstruktur 7 weist vorzugsweise eine Tiefe zwischen 100 nm und 10 µm auf.
Bei der Oberflächenstrukturierung 7 kann es sich um eine Aufrauung der Oberfläche der Funktionsschicht 6 handeln, die beispielsweise mit einem Ätzprozess erzeugt wird. Bei dieser Ausgestaltung ist die Oberflächenstrukturierung 7 eine nicht-periodische Struktur.
Bei einer bevorzugten Ausgestaltung handelt es sich bei der Oberflächenstrukturierung 7 der Funktionsschicht 6 um eine periodische Struktur. Beispiele für eine Funktionsschicht 6 mit einer derartigen periodischen Struktur 7 sind in den Figuren 2 und 3 dargestellt. Die periodische Struktur 7 weist Strukturelemente 8 auf, die in einem eindimensionalen oder mehrdimensionalen Gitter mit einer Periode d angeordnet sind. Bei den Strukturelementen 8 kann es sich beispielsweise um Erhebungen oder Vertiefungen wie z.B. Stege, Rillen oder Löcher handeln. Die Strukturelemente 8 können beispielsweise mittels Fotolithographie an der Oberfläche der Funktionsschicht 6 erzeugt werden. Vorzugsweise weisen die Strukturelemente 8 eine Höhe h zwischen 100 nm und 10 µm auf. Die Periode d der periodischen Struktur 7 liegt vorzugsweise in der Größenordnung der Wellenlänge der emittierten Strahlung, so dass die periodische Struktur 7 einen so genannten photonischen Kristall ausbildet.

Besonders vorteilhaft ist es, wenn die periodische Struktur 7 eine Periode d und die Funktionsschicht 6 einen Brechungsindex n₂ aufweist, wobei gilt: π/λ₂ < G < n₂ 2π/λ₂. Dabei ist λ₂ die Wellenlänge der konvertierten Strahlung und G = 2π/d im Fall einer eindimensionalen Gitterstruktur und G = 4π/√3d im Fall einer zweidimensionalen, insbesondere hexagonalen, Gitterstruktur.

Es hat sich herausgestellt, dass sich mit einer Periode d in diesem Bereich eine gerichtete Abstrahlung erzielen lässt, das heißt die Winkelverteilung der emittierten Strahlung ist stärker um die Hauptstrahlrichtung 13 herum konzentriert als beispielsweise bei einer nicht-periodisch strukturierten Funktionsschicht 6.

Alternativ kann die Oberflächenstrukturierung 7 auch durch Mikroprismen oder Mikrolinsen gebildet werden. In diesem Fall sind die Strukturelemente 8 typischerweise größer als die Wellenlänge λ₂ der emittierten Strahlung.

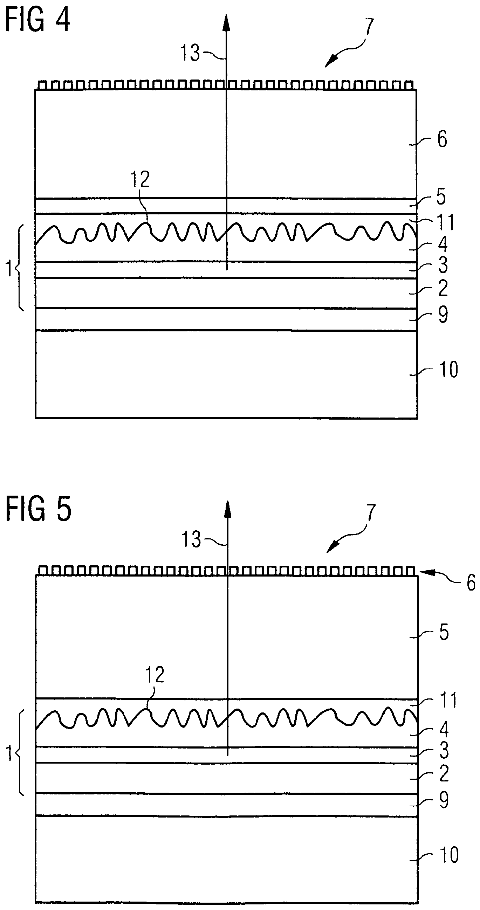

Das in Figur 4 dargestellte Ausführungsbeispiel eines strahlungsemittierenden Halbleiterbauelements unterscheidet sich von dem in Figur 1 dargestellten Ausführungsbeispiel dadurch, dass die Lumineszenzkonversionsschicht 5 eine mittels eines PVD (Physical Vapor Deposition)-Verfahrens hergestellte Schicht ist. Insbesondere kann die Lumineszenzkonversionsschicht 5 eine mittels Laserstrahlverdampfens (Pulsed Laser Deposition, PLD) hergestellte Schicht sein. Die Lumineszenzkonversionsschicht 5 kann insbesondere auf die Funktionsschicht 6 abgeschieden sein, das heißt die Funktionsschicht 6 fungiert als Substrat für das Aufbringen der Lumineszenzkonversionsschicht 5 mittels eines PVD-Verfahrens. Die Funktionsschicht 6 ist dazu aus einem vorzugsweise anorganischen Material ausgebildet, das eine ausreichend mechanische Stabilität aufweist, so dass es als selbsttragendes Substrat verwendet werden kann. Insbesondere kann die Funktionsschicht 6 ein Saphirsubstrat sein. Alternativ ist es auch möglich, dass die Funktionsschicht 6 wie bei dem in Figur 1 beschriebenen Ausführungsbeispiel aus einem Glas, einer Keramik oder einer Glaskeramik gebildet ist. Die Funktionsschicht 6 weist eine Oberflächenstrukturierung 7 auf, die insbesondere zur Verbesserung der Strahlungsauskopplung dient und wie im Zusammenhang mit den Figuren 1 bis 3 beschrieben ausgestaltet sein kann.

Bei einem Herstellungsverfahren zur Herstellung des Halbleiterbauelements kann beispielsweise zunächst eine Oberfläche der Funktionsschicht 6 mit einer Oberflächenstrukturierung 7 versehen werden und nachfolgend die Lumineszenzkonversionsschicht 5 auf die der Oberflächenstrukturierung 7 gegenüberliegende Oberfläche abgeschieden werden. Alternativ können diese Verfahrensschritte auch in umgekehrter Reihenfolge durchgeführt werden. Die auf diese Weise separat hergestellte Kombination aus Funktionsschicht 6 und Lumineszenzkonversionsschicht 5 kann beispielsweise in einem weiteren Verfahrensschritt mittels einer Verbindungsschicht 11 mit dem Halbleiterkörper 1 des strahlungsemittierenden Halbleiterbauelements verbunden werden.

Weitere Details und vorteilhafte Ausgestaltungen des in Figur 4 dargestellten Ausführungsbeispiels entsprechen dem zuvor in Figur 1 dargestellten Ausführungsbeispiel und werden daher nicht nochmals näher erläutert.

Bei dem in Figur 5 dargestellten Ausführungsbeispiel ist wie bei dem in Figur 1 dargestellten Ausführungsbeispiel eine Lumineszenzkonversionsschicht 5 mittels einer Verbindungsschicht 11 mit dem Halbleiterkörper 1 des strahlungsemittierenden Halbleiterbauelements verbunden. Die Lumineszenzkonversionsschicht 5 ist eine selbsttragende Schicht, die vorzugsweise aus einem Glas, einer Keramik oder einer Glaskeramik gebildet ist. Die Lumineszenzkonversionsschicht 5 weist an ihrer Oberfläche eine Oberflächenstrukturierung 7 auf, die insbesondere zur Verbesserung der Strahlungsauskopplung aus der Lumineszenzkonversionsschicht 5 dient. In diesem Fall fungiert die Oberflächenstrukturierung 7 der Lumineszenzkonversionsschicht 5 als Funktionsschicht 6. Die Funktionsschicht 6 ist in diesem Fall also nicht als separate Schicht hergestellt, sondern in Form einer Oberflächenstrukturierung 7 in der Lumineszenzkonversionsschicht 5 ausgebildet.

Hinsichtlich weiterer Details und vorteilhafter Ausgestaltungen entspricht das in Figur 5 dargestellte Ausführungsbeispiel dem in Figur 1 dargestellten Ausführungsbeispiel.

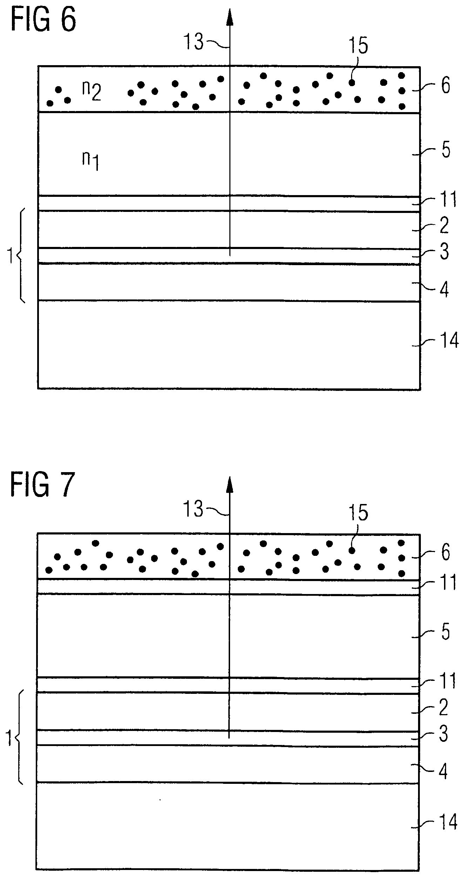

Das in Figur 6 dargestellte strahlungsemittierende Halbleiterbauelement ist eine Lumineszenzdiode mit einem Halbleiterkörper 1, der eine strahlungsemittierende aktive Schicht 3 enthält. Die aktive Schicht 3 ist beispielsweise zwischen einem n-Typ-Halbleiterbereich 4 und einem p-Typ-Halbleiterbereich 2 angeordnet. Die Halbleiterschichten 2, 3, 4 des Halbleiterkörpers 1 können auf einem Aufwachssubstrat 14 aufgewachsen sein. Alternativ ist es auch möglich, dass der Halbleiterkörper 1 ein Dünnfilm-Halbleiterkörper ist, bei dem das Aufwachssubstrat 14 abgelöst ist und der Halbleiterkörper 1 stattdessen auf einem vom Aufwachssubstrat 14 verschiedenen Trägerkörper angeordnet ist, wie es beim Ausführungsbeispiel der Figur 1 der Fall ist.

Der strahlungsemittierenden aktiven Schicht 3 ist in der Hauptstrahlungsrichtung 13 eine Lumineszenzkonversionsschicht 5 nachgeordnet. Die Lumineszenzkonversionsschicht 5 ist vorteilhaft aus einem Glas, einer Keramik oder einer Glaskeramik gebildet. Die Lumineszenzkonversionsschicht 5 weist einen Lumineszenzkonversionsstoff auf, der einen Teil der von der aktiven Schicht 3 emittierten Strahlung mit einem Intensitätsmaximum bei ersten Wellenlänge λ₁ in Strahlung mit einem Intensitätsmaximum bei einer zweiten Wellenlänge λ₂ konvertiert, wobei die Wellenlänge λ₂ größer als die Wellenlänge λ₁ ist. Die Lumineszenzkonversionsschicht kann insbesondere Ce-dotierte Granate wie YAG:Ce, LuAG:Ce oder Eu-dotierte Nitride oder Oxinitride aufweisen. Die Lumineszenzkonversionsschicht 5 ist vorzugsweise eine selbsttragende Schicht, die beispielsweise mit einer Verbindungsschicht 11 mit dem Halbleiterkörper 1 verbunden sein kann.

Der Lumineszenzkonversionsschicht 5 folgt in der Hauptstrahlungsrichtung 13 eine Funktionsschicht 6 nach. Die Funktionsschicht 6 weist vorzugsweise einen Brechungsindex n₂ auf, der kleiner als der Brechungsindex n₁ der Lumineszenzkonversionsschicht 5 ist. Auf diese Weise wird ein abrupter Brechungsindexsprung vom Brechungsindex n₁ der Lumineszenzkonversionsschicht 5 zum Umgebungsmedium um mindestens eine Zwischenstufe vermindert und auf diese Weise die Strahlungsauskopplung aus dem strahlungsemittierenden Halbleiterbauelement verbessert.

Bei einer vorteilhaften Ausgestaltung weist die Funktionsschicht 6 Streupartikel 15 auf. Anstelle von Streupartikeln 15, die insbesondere einen höheren Brechungsindex als das umgebende Material der Funktionsschicht 6 aufweisen, kann die Funktionsschicht 6 auch Poren aufweisen, die einen geringeren Brechungsindex als das umgebende Material der Funktionsschichten aufweisen. Durch die Streupartikel 15 oder Poren in der Funktionsschicht 6 wird eine Lichtstreuung bewirkt, durch die vorteilhaft die Winkelabhängigkeit des Farborts der emittierten Strahlung vermindert wird. Die Streupartikel 15 können weiterhin auch von außen auf das strahlungsemittierende Halbleiterbauelement auftreffende Strahlung streuen und auf diese Weise vorteilhaft bewirken, dass die Oberfläche des strahlungsemittierenden Halbleiterbauelements im ausgeschalteten Zustand weiß erscheint. Ein eventuell störender gelblicher Farbeindruck der Lumineszenzkonversionsschicht 5 im ausgeschalteten Zustand des strahlungsemittierenden Halbleiterbauelements wird auf diese Weise vermindert.

Die Funktionsschicht 6 weist vorzugsweise ein Grundmaterial auf, das ein Glas, eine Keramik oder eine Glaskeramik ist, in das beispielsweise die Streupartikel 15 eingebettet sind. Die Funktionsschicht 6 kann insbesondere durch Sintern oder Schmelzen mit der Lumineszenzkonversionsschicht 5 verbunden werden. In diesem Fall ist vorteilhaft keine zusätzliche Verbindungsschicht wie beispielsweise eine Klebstoffschicht zwischen der Lumineszenzkonversionsschicht 5 und der Funktionsschicht 6 enthalten. Die Anzahl optisch wirksamer Grenzflächen, durch die die Strahlungsauskopplung möglicherweise negativ beeinflusst werden könnte, wird auf diese Weise vermindert.

Alternativ wäre es aber auch denkbar, dass die Funktionsschicht 6 mit einer transparenten Verbindungsschicht 11 mit der Lumineszenzkonversionsschicht 5 verbunden ist. Diese Ausgestaltung ist in Figur 7 dargestellt. Bei der Verbindungsschicht 11 zwischen der Funktionsschicht 6 und der Lumineszenzkonversionsschicht 5 kann es sich in diesem Fall beispielsweise um eine Silikon- oder Epoxidharzschicht handeln. Mittels einer weiteren Verbindungsschicht 11, die ebenfalls eine Silikon- oder Epoxidharzschicht sein kann, ist die Lumineszenzkonversionsschicht 5 mit dem Halbleiterkörper 1 verbunden. Ansonsten entspricht das in Figur 7 dargestellte Ausführungsbeispiel dem in Figur 6 dargestellten Ausführungsbeispiel.

Bei den zuvor beschriebenen Ausführungsbeispielen ist die Funktionsschicht 6 jeweils an der Strahlungsauskoppelfläche des strahlungsemittierenden Halbleiterbauelements angeordnet. Es sind aber auch Varianten des strahlungsemittierenden Halbleiterbauelements denkbar, bei denen die Funktionsschicht 6 nicht oder nicht nur an der Strahlungsauskoppelfläche des strahlungsemittierenden Halbleiterbauelements angeordnet ist.

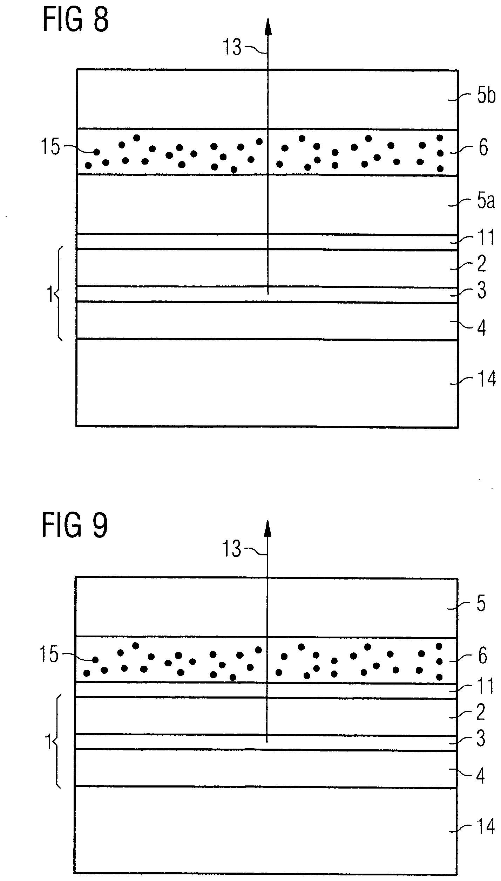

Bei dem in Figur 8 schematisch dargestellten Ausführungsbeispiel ist die Funktionsschicht 6 zwischen einer ersten Teilschicht 5a und einer zweiten Teilschicht 5b der Lumineszenzkonversionsschicht angeordnet. In diesem Fall kann die Funktionsschicht 6 insbesondere Streupartikel 15 enthalten, die das von der aktiven Schicht 3 und der ersten Teilschicht 5a der Lumineszenzkonversionsschicht emittierte Licht streut und somit eine verbesserte Farbmischung und eine verringerte Winkelabhängigkeit des Farborts bewirkt. Ansonsten entspricht das in Figur 8 dargestellte Ausführungsbeispiel dem in Figur 6 dargestellten Ausführungsbeispiel.

Bei dem in Figur 9 schematisch dargestellten Ausführungsbeispiel eines strahlungsemittierenden Halbleiterbauelements ist die Funktionsschicht 6 zwischen dem Halbleiterkörper 1 und der Lumineszenzkonversionsschicht 5 angeordnet. Bei dieser Ausgestaltung weist die Funktionsschicht 6 vorzugsweise einen Brechungsindex auf, der zwischen dem Brechungsindex des Halbleiterkörpers 1 und dem Brechungsindex der Lumineszenzkonversionsschicht 5 liegt. Auf diese Weise werden durch die Funktionsschicht 6 vorteilhaft Reflexionsverluste beim Übergang der Strahlung von dem Halbleiterkörper 1 zur Lumineszenzkonversionsschicht 5 vermindert. Die Funktionsschicht 6 kann wie bei dem vorherigen Ausführungsbeispiel Streupartikel 15 enthalten, um beispielsweise die Winkelverteilung der von der aktiven Schicht 3 emittierten Strahlung zu verändern.

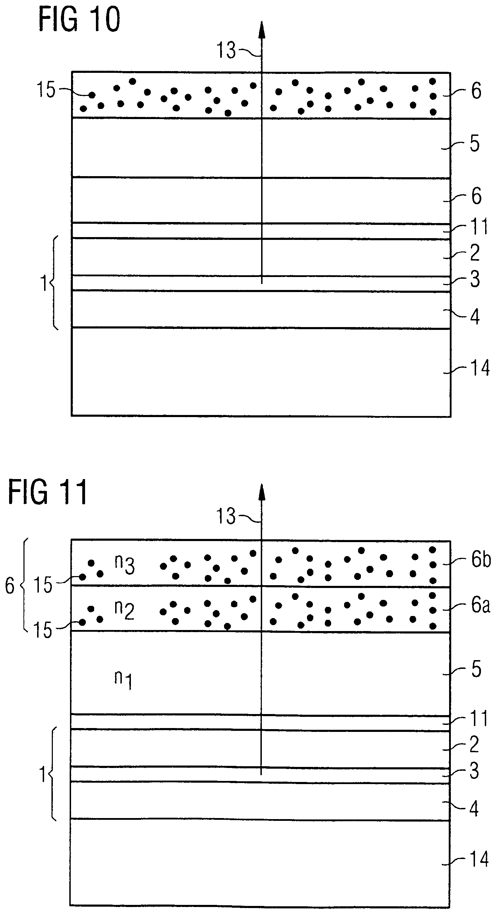

Beim dem in Figur 10 dargestellten Ausführungsbeispiel sind Funktionsschichten 6 in der Hauptstrahlungsrichtung 13 gesehen sowohl oberhalb als auch unterhalb der Lumineszenzkonversionsschicht 5 angeordnet. Durch die in der Hauptstrahlungsrichtung 13 oberhalb der Lumineszenzkonversionsschicht 5 angeordnete Funktionsschicht 6 wird vorteilhaft die Strahlungsauskopplung aus dem strahlungsemittierenden Halbleiterbauelement verbessert sowie durch vorzugsweise darin enthaltende Streupartikel 15 eine Verringerung der Winkelabhängigkeit des Farborts und ein weißes Erscheinungsbild der Lumineszenzkonversionsschicht 5 im ausgeschalteten Zustand des strahlungsemittierenden Halbleiterbauelements erzielt. Die vorteilhaften Eigenschaften und Wirkungsweisen der oberhalb der Lumineszenzkonversionsschicht 5 angeordneten Funktionsschicht 6 entsprechen daher dem in Figur 6 dargestellten Ausführungsbeispiel. Die in der Hauptstrahlungsrichtung 13 unterhalb der Lumineszenzkonversionsschicht 5 angeordnete Funktionsschicht 6 dient wie bei dem in Figur 9 dargestellten Ausführungsbeispiel insbesondere dazu, Reflexionsverluste an der Grenzfläche zwischen dem Halbleiterkörper 1 und der Lumineszenzkonversionsschicht 5 zu vermindern. Die unterhalb der Lumineszenzkonversionsschicht 5 angeordnete Funktionsschicht 6 weist dazu vorteilhaft einen Brechungsindex auf, der zwischen dem Brechungsindex des Halbleitermaterials und dem Brechungsindex der Lumineszenzkonversionsschicht 5 liegt. Bei dem Ausführungsbeispiel der Figur 10 sind somit die Vorteile einer Funktionsschicht oberhalb der Lumineszenzkonversionsschicht 5 und einer Funktionsschicht 6 unterhalb der Lumineszenzkonversionsschicht 5 gemeinsam verwirklicht.

Bei dem in Figur 11 schematisch dargestellten Ausführungsbeispiel ist der Lumineszenzkonversionsschicht 5 in der Hauptstrahlungsrichtung 13 eine Funktionsschicht 6 mit einer ersten Teilschicht 6a und einer zweiten Teilschicht 6b nachgeordnet. Die der Lumineszenzkonversionsschicht 5 in der Hauptstrahlungsrichtung 13 nachfolgende erste Teilschicht 6a der Funktionsschicht 6 weist einen Brechungsindex n₂ auf, der kleiner als der Brechungsindex n₁ der Lumineszenzkonversionsschicht ist. Die der ersten Teilschicht 6a der Funktionsschicht 6 in der Hauptstrahlungsrichtung 13 nachfolgende zweite Teilschicht 6b der Funktionsschicht 6 weist einen Brechungsindex n₃ auf, der kleiner ist als der Brechungsindex n₂ der ersten Teilschicht 6a. Der Übergang vom Brechungsindex n₁ der Lumineszenzkonversionsschicht 5 zum Brechungsindex des Umgebungsmediums erfolgt also vorteilhaft nicht abrupt, sondern in mehreren Stufen. Auf diese Weise können Reflexionverluste an der Strahlungsauskoppelseite des strahlungsemittierenden Halbleiterbauelements besonders effektiv verringert werden.

Die erste Teilschicht 6a und/oder die zweite Teilschicht 6b der Funktionsschicht 6 können Streupartikel 15 aufweisen, um die Farbmischung der von der aktiven Schicht 3 emittierten Strahlung und der von der Lumineszenzkonversionsschicht 5 konvertierten Strahlung zu verbessern und/oder um das strahlungsemittierende Halbleiterbauelement im ausgeschalteten Zustand von außen betrachtet weiß erscheinen zu lassen.

Die Konzentration der Steupartikel 15 ist vorteilhaft in der ersten Teilschicht der Funktionsschicht 6a geringer als in der zweiten Teilschicht 6b. Die Konzentration der Streupartikel 15 nimmt also in der Hauptstrahlungsrichtung 13 von Teilschicht zu Teilschicht der Funktionsschicht 6 ab oder weist innerhalb der Funktionsschicht 6 einen in der Hauptstrahlungsrichtung 13 kontinuierlich abfallenden Gradienten auf. Die geringere Konzentration der Streupartikel in der Nähe des Halbleiterkörpers 1 und der Lumineszenzkonversionsschicht 5 hat den Vorteil einer geringeren Rückstreuung der emittierten Strahlung, wodurch sich die Effizienz des strahlungsemittierenden Halbleiterbauelements verbessert.

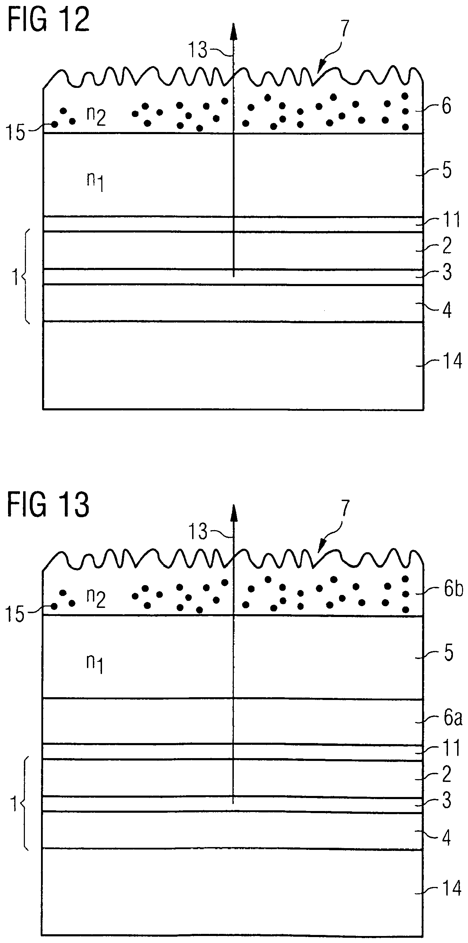

Bei dem in Figur 12 dargestellten Ausführungsbeispiel eines strahlungsemittierenden Halbleiterbauelements ist wie bei dem in Figur 6 dargestellten Ausführungsbeispiel eine Funktionsschicht 6 mit einem Brechungsindex n₂ der Lumineszenzkonversionsschicht 5 mit dem Brechungsindex n₁ in der Hauptstrahlungsrichtung 13 nachgeordnet, wobei n₂ ≤ n₁ ist. Im Unterschied zu dem in Figur 6 dargestellten Ausführungsbeispiel ist die Funktionsschicht 6 an der von der Lumineszenzkonversionsschicht 5 abgewandten Oberfläche mit einer Oberflächenstrukturierung 7 versehen. Durch die Oberflächenstrukturierung 7 können insbesondere Reflexionsverluste an der Strahlungsauskoppelfläche des strahlungsemittierenden Halbleiterbauelements weiter vermindert werden.

Die Oberflächenstrukturierung 7 kann insbesondere mit einem Ätzprozess erzeugt werden. In diesem Fall ist die Funktionsschicht 6 vorteilhaft aus einem Material gebildet, das bei dem verwendeten Ätzverfahren eine größere Ätzrate aufweist als die Lumineszenzkonversionsschicht 5. Die Lumineszenzkonversionsschicht 5 ist vorteilhaft gegenüber dem Ätzverfahren weitestgehend stabil. Bei der Oberflächenstrukturierung 7 kann es sich um eine nicht-periodische Struktur oder auch um eine periodische Struktur handeln. Im Fall einer periodischen Struktur kann diese eine photonischen Kristall ausbilden, wie beispielsweise im Zusammenhang mit den Figuren 2 und 3 erläutert.

Die Funktionsschicht 6 kann Streupartikel 15 aufweisen, um die Winkelabhängigkeit des Farborts zu vermindern und/oder die Lumineszenzkonversionsschicht 5 von außen gesehen weiß erscheinen zu lassen, wenn sich das strahlungsemittierende Halbleiterbauelement im ausgeschalteten Zustand befindet. Weiterhin kann auch die Oberflächenstrukturierung 7 lichtstreuende Eigenschaften aufweisen, so dass gegebenenfalls auch auf die Streupartikel 15 verzichtet werden kann.

Das in Figur 13 dargestellte Ausführungsbeispiel eines strahlungsemittierenden Halbleiterbauelements weist wie das in Figur 12 dargestellte Halbleiterbauelement eine Funktionsschicht 6b mit einer Oberflächenstrukturierung 7 auf, die der Lumineszenzkonversionsschicht 5 in der Hauptstrahlungsrichtung 13 nachfolgt. Der Unterschied zum in Figur 12 dargestellten Ausführungsbeispiel besteht darin, dass zusätzlich in der Hauptstrahlungsrichtung 13 gesehen unterhalb der Lumineszenzkonversionsschicht 5 eine weitere Teilschicht 6a der Funktionsschicht angeordnet ist. Die unterhalb der Lumineszenzkonversionsschicht 5 angeordnete zweite Teilschicht 6a dient wie bei den in den Figuren 9 und 10 dargestellten Ausführungsbeispielen im Wesentlichen dazu, Reflexionsverluste beim Übertritt der Strahlung von dem Halbleiterkörper 1 in die Lumineszenzkonversionsschicht 5 zu verringern. Die unterhalb der Lumineszenzkonversionsschicht 5 angeordnete Teilschicht 6a der Funktionsschicht weist dazu vorzugsweise einen Brechungsindex auf, der zwischen den Brechungsindizes des Halbleiterkörpers 1 und der Lumineszenzkonversionsschicht 5 liegt.

Sowohl die unterhalb der Lumineszenzkonversionsschicht 5 angeordnete erste Teilschicht 6a als auch die oberhalb der Lumineszenzkonversionsschicht 5 angeordnete zweite Teilschicht 6b der Funktionssicht 6 können jeweils Streupartikel 15 aufweisen. In diesem Fall ist es vorteilhaft, wenn die erste Teilschicht 6a eine geringere Konzentration an Streupartikeln 15 aufweist als die zweite Teilschicht 6b. Insbesondere ist es möglich, dass nur die zweite Teilschicht 6b der Funktionsschicht Streupartikel 15 aufweist. Auf diese Weise wird vorteilhaft erreicht, dass die Rückstreuung von Strahlung in der unterhalb der Lumineszenzkonversionsschicht 6 angeordneten ersten Teilschicht 6b gering ist.
Die Erfindung ist nicht durch die Beschreibung anhand der Ausführungsbeispiele beschränkt. Der Schutzbereich wird durch die Ansprüche definiert.

## Patentansprüche

1. Strahlungsemittierendes Halbleiterbauelement mit
- einem Halbleiterkörper (1), der eine aktive Schicht (3) aufweist, die im Betrieb elektromagnetische Strahlung einer ersten Wellenlänge λ₁ in eine Hauptstrahlungsrichtung (13) emittiert,
- einer Lumineszenzkonversionsschicht (5), die zumindest einen Teil der emittierten Strahlung in Strahlung einer zweiten Wellenlänge λ₂ konvertiert, die größer ist als die erste Wellenlänge λ₁, und
- einer Funktionsschicht (6) zur Verbesserung der Winkelabhängigkeit der emittierten Strahlung,
wobei die Funktionsschicht (6) der aktiven Schicht (3) und der Lumineszenzkonversionsschicht (5) in der Hauptstrahlungsrichtung (13) nachfolgt und ein Glas, eine Keramik, eine Glaskeramik oder Saphir enthält,
wobei die Funktionsschicht (6) eine Oberflächenstrukturierung (7) aufweist, die eine eindimensionale oder zweidimensionale periodische Struktur aufweist, und
wobei die periodische Struktur eine Periode d und die Funktionsschicht (6) einen Brechungsindex n₂ aufweist, wobei gilt:
π/λ₂ < G < n₂ 2π/λ₂, mit G = 2π/d im Fall einer eindimensionalen periodischen Struktur und G = 4π/√3d im Fall einer zweidimensionalen, insbesondere hexagonalen, periodischen Struktur.

2. Strahlungsemittierendes Halbleiterbauelement nach Anspruch 1,
bei dem die Lumineszenzkonversionsschicht (5) einen Brechungsindex n₁ und die Funktionsschicht (6) einen Brechungsindex n₂ aufweist, wobei n₂ ≤ n₁ gilt.

3. Strahlungsemittierendes Halbleiterbauelement nach einem der vorhergehenden Ansprüche,
bei dem die Lumineszenzkonversionsschicht (5) einen Brechungsindex n₁ und die Funktionsschicht (6) einen Brechungsindex n₂ aufweist, wobei Δn = |n₂ - n₁| ≤ 0,3 gilt.

4. Strahlungsemittierendes Halbleiterbauelement nach einem der vorhergehenden Ansprüche,
wobei die Lumineszenzkonversionsschicht (5) eine Keramik aufweist.

5. Strahlungsemittierendes Halbleiterbauelement nach einem der vorhergehenden Ansprüche,
wobei die Funktionsschicht (6) Aluminiumoxid, Aluminiumoxinitrid, Magnesiumaluminiumspinell, Siliziumdioxid, Siliziumoxinitrid, Quarzglas, amorphes Germaniumoxid (GeO₂), Natron-Kalk-Glas, Silikatglas, Borosilikatglas oder ein Spin-On-Glas aufweist.

6. Strahlungsemittierendes Halbleiterbauelement nach einem der vorhergehenden Ansprüche,
wobei zwischen der Funktionsschicht (6) und der Lumineszenzkonversionsschicht (5) keine Verbindungsschicht angeordnet ist.

7. Strahlungsemittierendes Halbleiterbauelement nach einem der vorhergehenden Ansprüche,
wobei die Oberflächenstrukturierung (7) eine Tiefe zwischen 100 nm und 10 µm aufweist.

8. Strahlungsemittierendes Halbleiterbauelement nach einem der vorhergehenden Ansprüche,
wobei die Funktionsschicht (6) Poren oder Streupartikel (15) aufweist.

9. Strahlungsemittierendes Halbleiterbauelement nach einem der vorhergehenden Ansprüche,
wobei die Lumineszenzkonversionsschicht (5) weder Poren noch Streupartikel aufweist.

10. Strahlungsemittierendes Halbleiterbauelement nach Anspruch 8 oder 9,
wobei die Funktionsschicht (6) mindestens zwei Teilschichten (6a, 6b) aufweist, wobei die Konzentrationen der Streupartikel (15) in den Teilschichten (6a, 6b) in der Hauptstrahlungsrichtung (13) von Teilschicht zu Teilschicht abnehmen.

11. Strahlungsemittierendes Halbleiterbauelement nach einem der vorhergehenden Ansprüche,
wobei die Funktionsschicht (6) mindestens zwei Teilschichten (6a, 6b) aufweist, wobei die Brechungsindizes in den Teilschichten (6a, 6b) in der Hauptstrahlungsrichtung (13) von Teilschicht zu Teilschicht abnehmen.

## Claims

1. A radiation-emitting semiconductor component comprising
- a semiconductor body (1) having an active layer (3), which, during operation, emits electromagnetic radiation having a first wavelength λ₁ in a main radiation direction (13),
- a luminescence conversion layer (5), which converts at least part of the emitted radiation into radiation having a second wavelength λ₂, which is greater than the first wavelength λ₁, and
- a functional layer (6) for improving the radiation coupling-out of the emitted radiation,
wherein the functional layer (6) succeeds the active layer (3) and the luminescence conversion layer (5) in the main radiation direction (13) and contains a glass, a ceramic, a glass ceramic or sapphire,
wherein the functional layer (6) has a surface structuring (7), wherein the surface structuring (7) has a one-dimensional or two-dimensional periodic structure, and
wherein the periodic structure has a period d and the functional layer (6) has a refractive index n₂, where the following holds true:
π/λ₂ < G < n₂ 2π/λ₂, where G = 2n/d in the case of a one-dimensional periodic structure and G = 4π/√3d in the case of a two-dimensional, in particular hexagonal, periodic structure.

2. The radiation-emitting semiconductor component according to claim 1,
wherein the luminescence conversion layer (5) has a refractive index n₁ and the functional layer (6) has a refractive index n₂, where n₂ ≤ n₁ holds true.

3. The radiation-emitting semiconductor component according to any of the preceding claims,
wherein the luminescence conversion layer (5) has a refractive index n₁ and the functional layer (6) has a refractive index n₂, where Δn = |n₂ - n₁| ≤ 0.3 holds true.

4. The radiation-emitting semiconductor component according to any of the preceding claims,
wherein the luminescence conversion layer (5) comprises a ceramic.

5. The radiation-emitting semiconductor component according to any of the preceding claims,
wherein the functional layer (6) comprises aluminum oxide, aluminum oxynitride, magnesium-aluminum spinel, silicon dioxide, silicon oxynitride, quartz glass, amorphous germanium oxide (GeO₂), soda-lime glass, silicate glass, borosilicate glass or a spin-on glass.

6. The radiation-emitting semiconductor component according to any of the preceding claims,
wherein no connecting layer is arranged between the functional layer (6) and the luminescence conversion layer (5).

7. The radiation-emitting semiconductor component according to any of the preceding claims,
wherein the surface structuring (7) has a depth of between 100 nm and 10 µm.

8. The radiation-emitting semiconductor component according to any of the preceding claims,
wherein the functional layer (6) comprises pores or scattering particles (15).

9. The radiation-emitting semiconductor component according to any of the preceding claims,
wherein the luminescence conversion layer (5) comprises neither pores nor scattering particles.

10. The radiation-emitting semiconductor component according to claim 8 or 9,
wherein the functional layer (6) comprises at least two partial layers (6a, 6b), wherein the concentrations of the scattering particles (15) in the partial layers (6a, 6b) decrease from partial layer to partial layer in the main radiation direction (13).

11. The radiation-emitting semiconductor component according to any of the preceding claims,
wherein the functional layer (6) comprises at least two partial layers (6a, 6b), wherein the refractive indices in the partial layers (6a, 6b) decrease from partial layer to partial layer in the main radiation direction (13) .

## Revendications

1. Composant semi-conducteur émetteur de rayonnement comportant
- un corps semi-conducteur (1) présentant une couche active (3) qui émet un rayonnement électromagnétique d'une première longueur d'onde λ₁ dans une direction principale de rayonnement (13) durant le fonctionnement,
- une couche de conversion de luminescence (5) convertissant au moins une partie du rayonnement émis en un rayonnement d'une deuxième longueur d'onde λ₂ supérieure à la première longueur d'onde λ₁,
- une couche fonctionnelle (6) pour améliorer la dépendance angulaire du rayonnement émis,
la couche fonctionnelle (6) suivant la couche active (3) et la couche de conversion de luminescence (5) dans la direction principale de rayonnement (13) et contenant un verre, une céramique, une vitrocéramique ou un saphir,
la couche fonctionnelle (6) présentant une structure de surface (7) définissant une structure périodique unidimensionnelle ou bidimensionnelle et
dans laquelle la structure périodique présente une période d et la couche fonctionnelle (6) un indice de réfraction n₂, pour lequel s'applique :
π/λ₂ < G < n₂ 2π/λ₂, où G = 2π/d dans le cas d'une structure périodique unidimensionnelle et G = 4π/√3d dans le cas d'une structure périodique bidimensionnelle, en particulier hexagonale.

2. Composant semi-conducteur émetteur de rayonnement selon la revendication 1,
dans lequel la couche de conversion de luminescence (5) présente un indice de réfraction n₁ et la couche fonctionnelle (6) un indice de réfraction n₂, pour lequel n₂ ≤ n₁ s'applique.

3. Composant semi-conducteur émetteur de rayonnement selon l'une des revendications précédentes,
dans lequel la couche de conversion de luminescence (5) présente un indice de réfraction n₁ et la couche fonctionnelle (6) un indice de réfraction n₂, où Δn = |n₂ - n₁| ≤ 0,3.

4. Composant semi-conducteur émetteur de rayonnement selon l'une des revendications précédentes,
dans lequel la couche de conversion de luminescence (5) comprend une céramique.

5. Composant semi-conducteur émetteur de rayonnement selon l'une des revendications précédentes,
dans lequel la couche fonctionnelle (6) comprend de de l'oxyde d'aluminium, de l'oxinitrure d'aluminium, du spinelle de magnésium-aluminium, du dioxyde de silicium, de l'oxinitrure de silicium, du verre de quartz, de l'oxyde de germanium amorphe (GeO₂), du verre sodocalcique, du verre silicate, du verre borosilicate ou un verre déposé par centrifugation.

6. Composant semi-conducteur émetteur de rayonnement selon l'une des revendications précédentes,
dans lequel aucune couche d'interconnexion n'est disposée entre la couche fonctionnelle (6) et la couche de conversion de luminescence (5).

7. Composant semi-conducteur émetteur de rayonnement selon l'une des revendications précédentes,
la structure de surface (7) ayant une profondeur comprise entre 100 nm et 10 µm.

8. Composant semi-conducteur émetteur de rayonnement selon l'une des revendications précédentes,
la couche fonctionnelle (6) présentant des pores ou des particules dispersées (15).

9. Composant semi-conducteur émetteur de rayonnement selon l'une des revendications précédentes,
dans lequel la couche de conversion de luminescence (5) ne présente ni pores, ni particules dispersées.

10. Composant semi-conducteur émetteur de rayonnement selon la revendication 8 ou 9,
dans lequel la couche fonctionnelle (6) comprend au moins deux couches partielles (6a, 6b), les concentrations des particules dispersées (15) dans les couches partielles (6a, 6b) diminuant d'une couche partielle à l'autre dans la direction principale de rayonnement (13).

11. Composant semi-conducteur émetteur de rayonnement selon l'une des revendications précédentes,
dans lequel la couche fonctionnelle (6) comprend au moins deux couches partielles (6a, 6b), les indices de réfraction dans les couches partielles (6a, 6b) diminuant d'une couche partielle à l'autre dans la direction principale de rayonnement (13).
